# EUROPEAN PATENT SPECIFICATION

(11) **EP 0 717 430 B1**
(45) Date of publication and mention of the grant of the patent: **09.09.1998**
(21) Application number: 95308914.1
(22) Date of filing: 08.12.1995
(51) Int. Cl.: H01J 37/20, H01L 21/00

(54) **Substrate loading apparatus**
Substrateneinschleusenvorrichtung
Dispositif de chargement de substrats

(30) Priority: 15.12.1994 GB 9425349
(43) Date of publication of application: 19.06.1996
(73) Proprietor: OXFORD PLASMA TECHNOLOGY LIMITED, Witney, Oxon OX8 1TL (GB)
(72) Inventor: Jones, Phillip Robert, Langford, Bristol, BS18 7HB (GB)
(74) Representative: Skone James, Robert Edmund

(56) References cited:
- US-A- 4 534 697
- US-A- 4 715 921
- US-A- 4 971 512
- US-A- 5 162 047
- PATENT ABSTRACTS OF JAPAN vol. 7 no. 178 (E-191) [1323] ,6 August 1983 & JP-A-58 084435 (HITACHI) 20 May 1983,

## Description

The present invention relates to substrate loading apparatus, in particular for loading a substrate into a thin-film processing system.

A conventional loading arm for loading a substrate into a thin-film processing system (such as a semiconductor processing vessel) comprises a single slidable rod with a substrate holder fixably attached to its distal end.

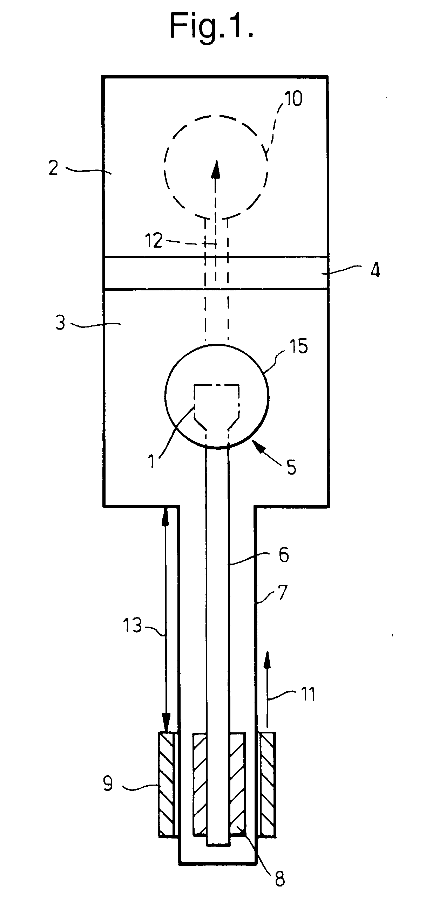

A conventional loading arm is shown in Figure 1 in its pre-loading position and loading position.

Before loading, substrate holder 1 is manually loaded with a silicon wafer 15. Processing chamber 2 and loading chamber 3 are then evacuated, after opening a valve 4. The substrate holder 1 is fixed to the distal end 5 of loading arm 6. The arm 6 extends from the rear of the loading chamber 3 into a loading arm chamber 7 (also evacuated). The rear end of the loading arm chamber 7 is fitted with a suitable magnetic material 8 which is attracted to a cylindrical magnetic slider 9 which is slidably mounted to the exterior of the loading arm chamber 7.

Substrate holder 1 is transferred into processing chamber 2 by manually sliding the magnetic slider 9 as indicated at 11.

This causes the loading arm 6 to move with the slider 9, and moves the substrate holder into the loaded position indicated by dotted lines at 10. The distance of travel 12 of the substrate holder 9 is limited by the allowable extent of travel 13 of the slider 9.

An example of a system of the type illustrated in Figure 1 is shown in US-A-4971512. JP-A-58084435 discloses a wafer carrier having three sliding arms which are driven by a rope wound round a number of sheeves.

According to the present invention there is provided apparatus for loading a substrate into a thin-film processing system chamber comprising a loading assembly having a substrate support mounted for movement between retracted and extended positions, the substrate support supporting a substrate in use whereby in the extended position the substrate is in the chamber, characterised in that the loading assembly comprises a carriage; first drive means for driving the carriage with respect to a base; and second drive means which moves with the carriage and cooperates with the base whereby the relative movement between the carriage and the base causes the second drive means to drive the substrate support with respect to the carriage.

Apparatus according to the invention presents a far more compact system than is provided by the prior art. By moving the carriage at a first speed, the second drive means automatically causes the substrate support to move at a second, higher speed in the direction of loading.

Typically the carriage is slidably mounted to the base (for instance it may be mounted to a fixed track on the base of a loading chamber) and the substrate support is slidably mounted to the carriage.

The second drive means may be provided with a separate power source, such as a motor, for driving the substrate support with respect to the carriage. Preferably, however, the first and second drive means are driven from a common source (e.g. a common drive motor).

In a preferable embodiment, the second drive means comprises first and second pulleys mounted to the carriage for movement therewith, and a drive belt mounted to the pulleys and fixed at one point to the base and at another point to the substrate support.

The first drive means may comprise any suitable means for moving the carriage with respect to the base, but preferably the first drive means also comprises a pair of pulleys connected by a drive belt, the drive belt being connected to the carriage.

Typically the substrate support and carriage have approximately the same length in the loading direction and lie in register with each other in their retracted positions (typically with the substrate support lying on top of the carriage). This arrangement ensures maximum compactness in the loading direction.

The loading assembly may be fixed and only required to load substrates into a single processing chamber. Alternatively, the loading assembly may be rotatably mounted for loading substrates into a plurality of chambers. The compact nature of the loading assembly makes it particularly suitable for this type of multiple processing arrangement, in which a number of processing chambers can be arranged round a single compact loading chamber.

The invention also extends to a thin film processing system comprising one or more processing chambers in which substrates are processed, and a loading assembly according to any of the preceding claims for loading the substrates.

Typically, the system is a plasma or ion beam processing system for treatment (for instance by plasma etching or plasma deposition) of semiconductor wafers. The processing chamber may comprise an etching/deposition chamber, Reactive Ion Etch (RIE) chamber, Plasma Enhanced Chemical Vapour Deposition (PECVD) chamber, resist stripping and passivation chamber, sputter deposition chamber, down-stream microwave etch chamber, Electron Cyclotron Resonance (ECR) chamber, or inductively coupled plasma (ICP) chamber. In the case of an ion beam processing system, the processing chamber may comprise a Reactive Ion Beam Etching (RIBE) chamber or a Chemically Assisted Ion Beam Etching (CAIBE) chamber.

The loading assembly arm may have more than two loading members mounted for relative telescopic movement, each adjacent member being connected by drive means such as a pulley and drive belt.

Three embodiments of the invention will now be described with reference to the accompanying drawings, in which;
Figure 1 is a conventional loading arm;
Figure 2 shows a first example of a loading arm according to the invention, in its retracted position;
Figure 3 shows the arm of Figure 2 in its extended position;
Figure 4 is a cross-section of Figure 3 along a line A-A;
Figure 5 is a second example, showing a rotatable assembly for loading multiple processing chambers; and
Figure 6 is a third example, showing a rotatable assembly for loading three processing chambers.

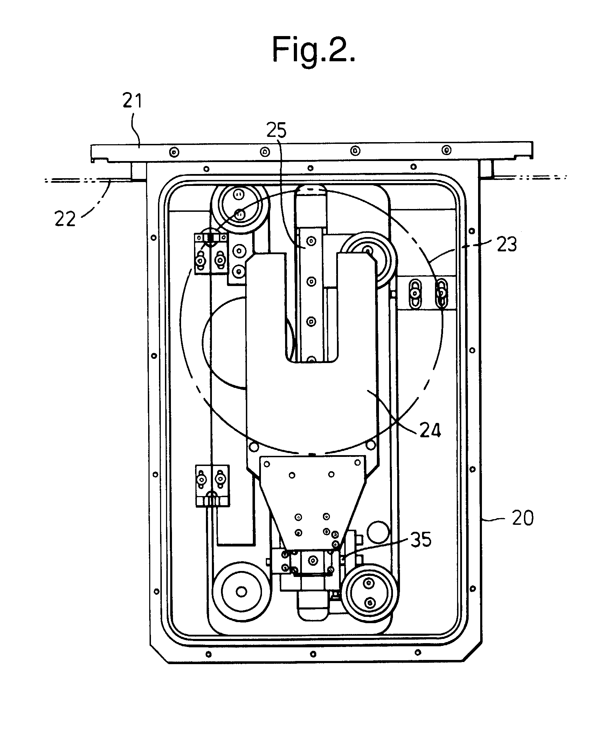

An example of loading apparatus according to the present invention is illustrated as a plan view in its retracted position in Figure 2.

Loading arm chamber 20 comprises a standard interface 21 conforming to the SEMI E21-91 standard. This allows the chamber 20 to be mounted in use to any suitable processing chamber interface. Before evacuating the loading chamber 20, a substrate 23 (indicated in dotted lines) such as a wafer is placed on substrate support 24. The position of the clean-room interface when fitted is indicated at 22. The lid of the loading chamber is removed for clarity.

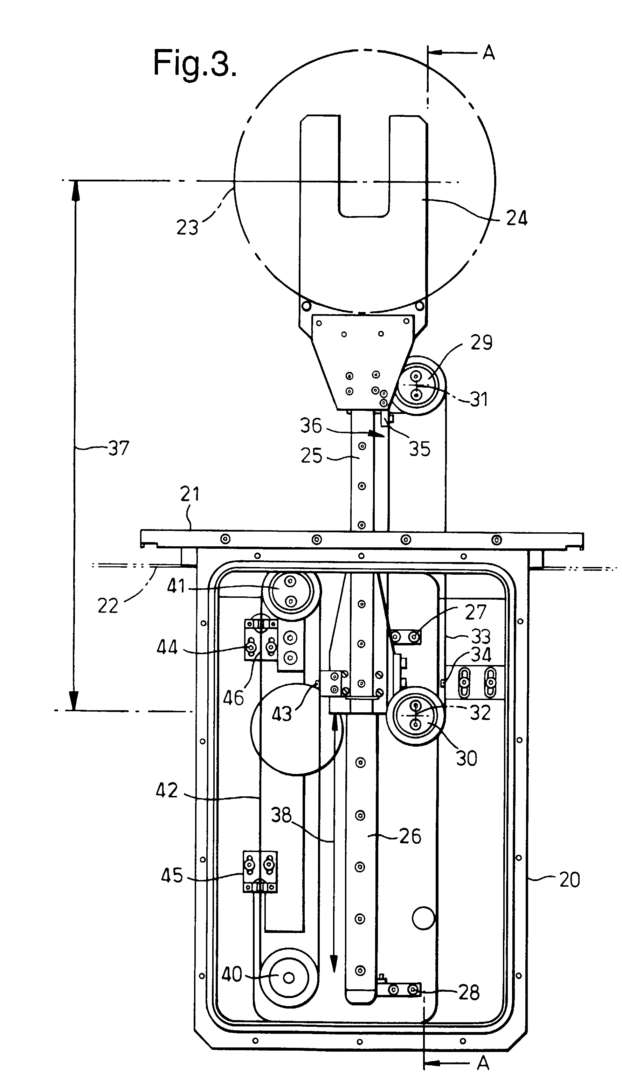

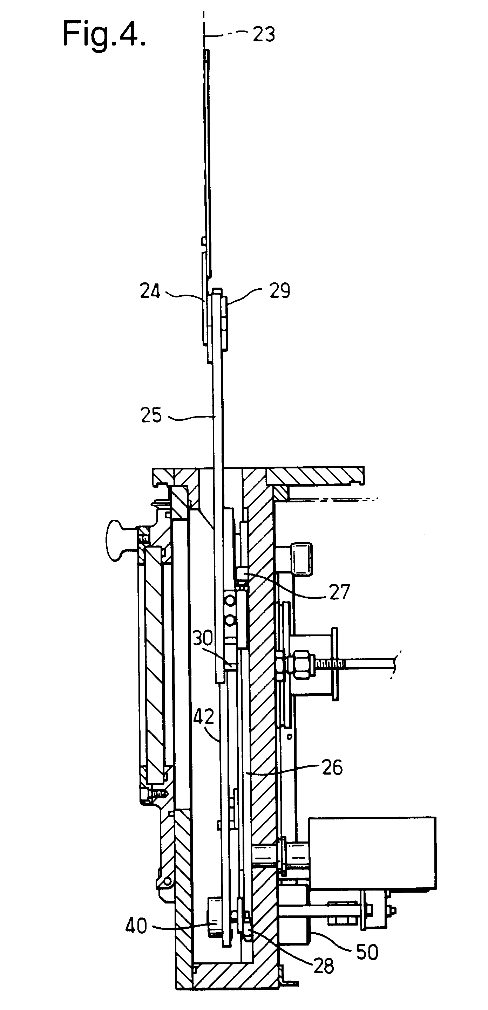

Figure 3 shows a plan view of the loading apparatus in its extended loading position. Figure 4 is a cross-section of Figure 3 along a line A-A. Substrate support 24 is slidably mounted on carriage 25 via a conventional linear bearing. Carriage 25 is slidably mounted on fixed rail 26, also via a conventional linear bearing.

Carriage 25 is mounted with pulleys 29,30 which rotate about axles 31 and 32 respectively. A drive belt comprising a closed loop of steel belt or wire 33 passes round the pulleys 29,30 and is fixed to the loading chamber 20 at 34, and to the substrate support 24 at 35. Therefore, linear movement of the carriage 25 (and associated pulleys 29,30) in the loading direction causes the pulleys to rotate clockwise (due to the fixing point 34). The combined linear movement of the arm 25, and driven movement of the steel belt or wire 33, causes the lefthand side 36 of the wire loop to move twice the speed and distance of carriage 25. Hence the substrate support 24, attached to the lefthand side 36 of the steel belt or wire 33 at fixing point 35 has a transfer distance 37 which is twice the transfer distance 38 of the carriage 25.

The telescopic movement and use of mechanical advantage allows a compact loading chamber. As can be seen from Figure 2, the substrate support 24 and carriage 25 have approximately the same length in the loading direction, and in its retracted position the substrate support 24 lies in register with the carriage 25. This provides a particularly compact construction.

Carriage 25 is driven by a pulley drive arrangement comprising a first drive pulley 40, a second driven pulley 41 and a closed loop of steel belt or wire 42 which passes round the pulleys 41,40. The steel belt or wire 42 is attached to the arm 25 at 43. Therefore, rotation of the drive pulley 40 in an anti-clockwise direction causes the arm 25 to move in the loading direction. The drive pulley 40 is driven by a drive motor 50 shown in Figure 4. Figure 4 also shows the layered relationship of the slide rail 26, carriage 25 and substrate support 24.

Optical detectors 44,45 detect the presence of a hole 46 in the belt or wire 42 to indicate that the arm 25 has reached its extended or retracted position. In the extended position of Figure 3 the hole has been detected by the detector 44. At this point, the detectors send a signal to motor 50, which causes it to stop rotating the drive pulley 40. If the optical detectors 44,45 fail to work, the extent of movement of carriage 25 is ultimately limited by mechanical stops 27,28.

One or both of the drive belts 33,42 may be mounted vertically, instead of horizontally as shown in Figures 2 to 4.

A typical sequence of events in a thin film processing system incorporating the loading assembly according to the invention will now be described.

Before operation, the wafer support is fully retracted into the loading chamber. To load a wafer into the process chamber, the following sequence of events occurs:
1. The operator opens the loading chamber door, places the wafer onto the wafer support, then closes the load lock door.
2. The loading chamber is pumped down to base pressure.
3. The pneumatically operated gate valve is opened.
4. The loading arm extends into the processing chamber.
5. The wafer is lifted from the wafer support by a wafer lift within the processing chamber, the wafer support is withdrawn from the chamber, and the wafer is lowered onto the processing table by the wafer lift.
6. As the substrate support reaches its fully retracted position within the loading chamber, the hole in steel belt 42 is detected by the photo diode to stop the DC motor 50.
7. The gate valve is closed and the load lock can be vented if required.

The above sequence of events is repeated to remove the wafer from the processing chamber.

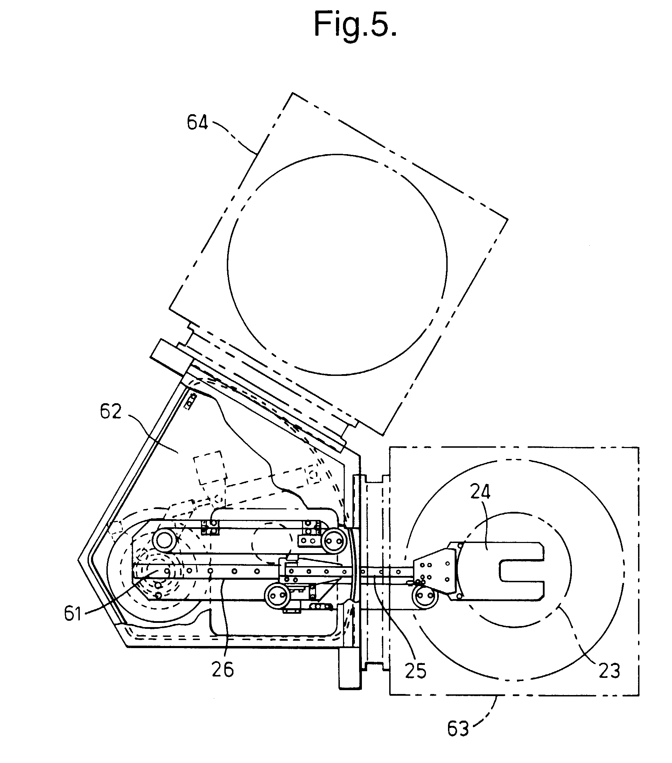

Figures 2 to 4 have shown the loading apparatus in a conventional, single process application. Figure 5 illustrate the utilization of the loading arm in a multiple processing arrangement. In Figure 5, the loading arm assembly is rotatably mounted about a pivot point 61 within a loading chamber 62. This allows the loading apparatus to load a substrate 23 into a first processing chamber 63 in a first position shown in Figure 5, or by anti-clockwise rotation about the pivot point 61 into a second position for loading a substrate into a second processing chamber 64.

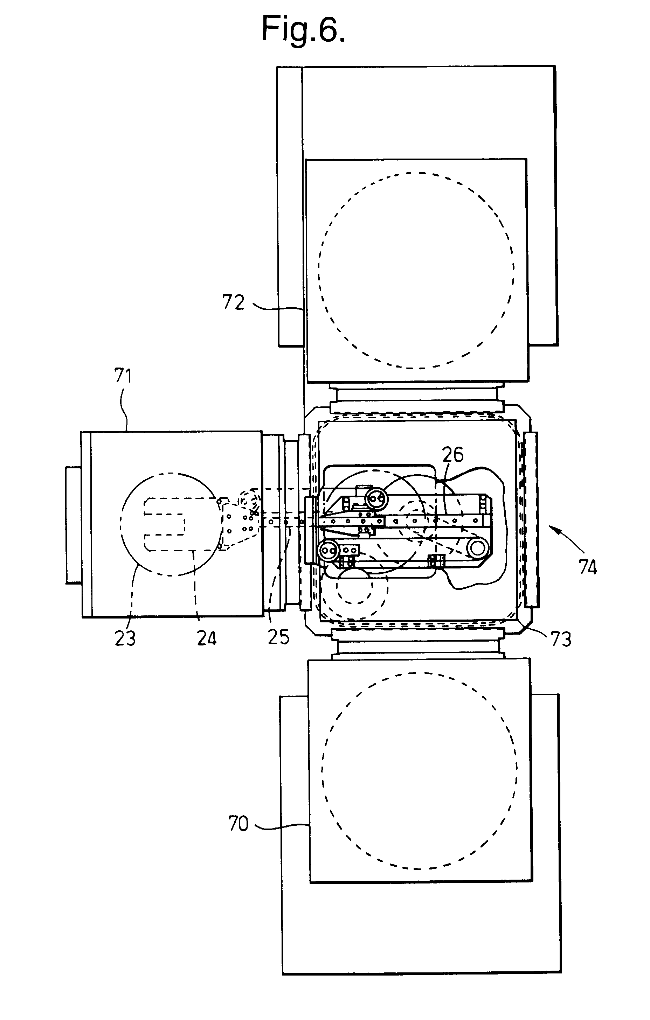

This principle may be extended to a range of more than two processing chambers distributed around the pivot point 61 as illustrated in the three chamber embodiment of Figure 6.

Wafer 23 may be loaded in sequence into processing chambers 70,72 arranged around the loading chamber 73. The arm receives a wafer from a wafer cassette chamber 71 (or a single substrate loadlock in the position of the cassette chamber 71) and then loads the wafer into the required processing chamber(s). An additional third processing chamber may also be added onto the position indicated at 74.

## Claims

1. Apparatus for loading a substrate into a thin-film processing system chamber comprising a loading assembly having a substrate support (24) mounted for movement between retracted and extended positions, the substrate support (24) supporting a substrate (23) in use whereby in the extended position the substrate is in the chamber, characterised in that the loading assembly comprises a carriage (25); first drive means (40,41,42,50) for driving the carriage with respect to a base; and second drive means (29,30,33) which moves with the carriage and cooperates with the base whereby the relative movement between the carriage and the base causes the second drive means to drive the substrate support with respect to the carriage.

2. Apparatus according to claim 1, wherein the carriage (25) is slidably mounted to the base (20) and the substrate support (24) is slidably mounted to the carriage (25).

3. Apparatus according to claim 1 or 2, wherein the first and second drive means are driven from a common source (50).

4. Apparatus according to any of the preceding claims, wherein the second drive means comprises first (29) and second (30) pulleys mounted to the carriage for movement therewith, and a drive belt (33) mounted to the pulleys and fixed at one point (34) to the base and at another point (35) to the substrate support.

5. Apparatus according to any of the preceding claims, wherein the first drive means comprises a pair of pulleys (40, 41) connected by a drive belt (42), the drive belt being connected to the carriage.

6. Apparatus according to any of the preceding claims, wherein the substrate support and carriage have approximately the same length in the loading direction and lie in register with each other in their retracted positions.

7. Apparatus according to any of the preceding claims, wherein the loading assembly is rotatably mounted (61) for loading substrates into a plurality of chambers.

8. A thin film processing system comprising one or more processing chambers in which substrates are processed, and a loading assembly according to any of the preceding claims for loading the substrates.

9. A system according to claim 8, wherein the system is a plasma processing system for treatment of semiconductor wafers.

## Patentansprüche

1. Vorrichtung zum Beschicken einer Dünnfilmverarbeitungssystem-Kammer mit einem Substrat, die eine Beschickungsbaugruppe mit einem Substratträger (24) umfaßt, der zwischen einer eingezogenen und einer ausgefahrenen Position beweglich angebracht ist, wobei der Substratträger (24) in Funktion ein Substrat (23) trägt und sich das Substrat in der ausgefahrenen Position in der Kammer befindet, **dadurch gekennzeichnet**, daß die Beschickungsbaugruppe einen Schlitten (25) umfaßt; eine erste Antriebseinrichtung (40, 41, 42, 50), die den Schlitten in bezug auf einen Untersatz antreibt; und eine zweite Antriebseinrichtung (29, 30, 33), die sich mit dem Schlitten bewegt und mit dem Untersatz zusammenwirkt, wobei die Bewegung des Schlittens und des Untersatzes zueinander bewirkt, daß die zweite Antriebseinrichtung den Substratträger in bezug auf den Schlitten antreibt.

2. Vorrichtung nach Anspruch 1, wobei der Schlitten (25) verschiebbar auf dem Untersatz (20) angebracht ist ist und der Substratträger (24) verschiebbar auf dem Schlitten (25) angebracht ist.

3. Vorrichtung nach Anspruch 1 oder 2, wobei die erste und die zweite Antriebseinrichtung von einer gemeinsamen Quelle (50) angetrieben werden.

4. Vorrichtung nach einem der vorangehenden Ansprüche, wobei die zweite Antriebseinrichtung eine erste (29) und eine zweite (30) Riemenscheibe umfaßt, die an dem Schlitten angebracht sind und sich mit ihm bewegen, sowie einen Antriebsriemen (33), der auf den Riemenscheiben angebracht und an einem Punkt (34) an dem Untersatz und an einem anderen Punkt (35) an dem Substratträger befestigt ist.

5. Vorrichtung nach einem der vorangehenden Ansprüche, wobei die erste Antriebseinrichtung ein Paar Riemenscheiben (40, 41) umfaßt, die durch einen Antriebsriemen (42) verbunden sind, wobei der Antriebsriemen mit dem Schlitten verbunden ist.

6. Vorrichtung nach einem der vorangehenden Ansprüche, wobei der Substratträger und der Schlitten ungefähr die gleiche Länge in der Beschickungsrichtung haben und einander in ihren eingezogenen Positionen überdecken.

7. Vorrichtung nach einem der vorangehenden Ansprüche, wobei die Beschikkungsbaugruppe drehbar angebracht ist (61), um eine Vielzahl von Kammern mit Substraten zu beschicken.

8. Dünnfilmbearbeitungssystem, das eine oder mehrere Bearbeitungskammern umfaßt, in denen Substrate bearbeitet werden, sowie eine Beschickungsbaugruppe nach einem der vorangehenden Ansprüche zum Beschicken mit den Substraten.

9. System nach Anspruch 8, wobei das System ein Plasmabearbeitungssystem zur Behandlung von Halbleiterwafern ist.

## Revendications

1. Appareil destiné à charger un substrat dans une chambre de système de traitement de films minces comprenant un ensemble de chargement comportant un support (24) de substrat monté pour déplacement entre des positions rétractée et déployée, le support (24) de substrat supportant, en utilisation, un substrat, ce par quoi, en position déployée, le substrat se trouve dans la chambre ; caractérisé en ce que l'ensemble de chargement comprend un chariot (25) ; un premier moyen (40, 41, 42, 50) d'entraînement destiné à entraîner le chariot par rapport à une base ; et un second moyen (29, 30, 33) d'entraînement qui se déplace avec le chariot et coopère avec la base, ce par quoi le déplacement relatif entre le chariot et la base fait que le second moyen d'entraînement entraîne le support de substrat par rapport au chariot.

2. Appareil selon la revendication 1, dans lequel le chariot (25) est monté coulissant sur la base (20) et dans lequel le support (24) de substrat est monté coulissant sur le chariot (25).

3. Appareil selon la revendication 1 ou 2, dans lequel les premier et second moyens d'entraînement sont entraînés par une source commune (50).

4. Appareil selon l'une quelconque des revendications précédentes, dans lequel le second moyen d'entraînement comprend des première (29) et seconde (30) poulies montées sur le chariot pour déplacement avec celui-ci, et une courroie (33) d'entraînement montée sur les poulies et fixée, à un point (34), à la base et, à un autre point (35), au support de substrat.

5. Appareil selon l'une quelconque des revendications précédentes, dans lequel le premier moyen d'entraînement comprend deux poulies (40, 41) reliées par une courroie (42) d'entraînement, la courroie d'entraînement étant reliée au chariot.

6. Appareil selon l'une quelconque des revendications précédentes, dans lequel le support de substrat et le chariot ont sensiblement la même longueur dans le sens de chargement et se trouvent décalés l'un par rapport à l'autre en position rétractée.

7. Appareil selon l'une quelconque des revendications précédentes, dans lequel l'ensemble (61) de chargement est monté mobile en rotation pour charger des substrats dans plusieurs chambres.

8. Système de traitement de films minces comprenant une ou plusieurs chambres de traitement dans lesquelles on traite des substrats, et un ensemble de chargement, selon l'une quelconque des revendications précédentes, destiné à charger les substrats.

9. Système selon la revendication 8, dans lequel le système est un système de traitement par plasma destiné à un traitement de plaquettes en semi-conducteur.
